# EUROPEAN PATENT APPLICATION

(11) **EP 4 726 072 A1**
(43) Date of publication of application: **15.04.2026**
(21) Application number: 25190937.0
(22) Date of filing: 22.07.2025
(51) Int. Cl.: C23C 16/448, C23C 16/455

(54) **PRECURSOR SUPPLY VESSEL**

(30) Priority: 25.07.2024 US 202463675539 P
(71) Applicant: ASM IP Holding B.V., 1322 AP Almere (NL)
(72) Inventor: BANKRAS, Radko, 1322 AP Almere (NL); JDIRA, Lucian, 1322 AP Almere (NL); VAN HAASTERT, Simon, 1322 AP Almere (NL); PROSERPIO, Davide, 1322 AP Almere (NL); WIEGERS, Frans, 1322 AP Almere (NL)
(74) Representative: V.O.

(57) **Abstract**

A precursor supply vessel is disclosed. The precursor supply vessel comprises a top wall, a bottom wall, and a side wall; a top wall heater configured and arranged to heat the top wall, a bottom wall heater configured and arranged to heat the bottom wall, and a side wall heater configured and arranged to heat the side wall. Each of the heaters is independently controllable.

## Description

### FIELD OF INVENTION

The present invention relates generally to semiconductor processing and, more particularly, to devices and methods for provision of precursors.

### BACKGROUND OF THE DISCLOSURE

In the semiconductor industry, various processes are used for forming thin films of materials on substrates such as silicon wafers. In chemical vapor deposition (CVD), reactant gases, also referred to herein as precursor gases, of different reactants are delivered to one or more substrates in a reaction chamber. The reactant gases react with one another in the reaction chamber to form thin films on the one or more substrates. In an atomic layer deposition (ALD) process, gaseous precursors are supplied, alternatingly and repeatedly, to the substrate or wafer to form a thin film of material on the wafer. One reactant adsorbs in a self-limiting process on the wafer. A different, subsequently pulsed reactant reacts with the adsorbed material to form a single molecular layer of the desired material.

In some cases, the vapors of source chemicals ("precursors") that are liquid or solid (e.g., molybdenum oxychloride) at ambient pressure and temperature are used. For some substances, the vapor pressure at room temperature is so low that they have to be heated to produce a sufficient amount of reactant vapor (vapor draw method). Typically, a semiconductor processing tool in a cleanroom will be connected to a bulk precursor supply located under the floor of the cleanroom for supplying gaseous precursor to the reaction chamber.

In applications wherein the reaction chamber contains multiple substrates having high surface enhancement, in which the effective surface area on which the precursor is to be deposited can be 400 or more times higher than the surface area of a flat substrate, large quantities of precursor in gaseous form are required to be provided within a certain time period. In such cases, direct supply of precursor gas from sub-fab to reaction chamber may not provide the required quantity and flow rate of precursor to result in acceptable deposition conditions and/or throughput.

### SUMMARY OF THE DISCLOSURE

According to a first aspect of the present invention, there is provided a precursor supply vessel comprising a top wall, a bottom wall, and a side wall; a top wall heater configured and arranged to heat the top wall, a bottom wall heater configured and arranged to heat the bottom wall, and a side wall heater configured and arranged to heat the side wall; wherein each of the heaters is independently controllable.

By providing heaters for each wall which are individually controllable, a high level of control over precursor behaviour within the vessel can be provided. For example, precursor can be prevented from being deposited on the side and top walls while being selectively deposited on the bottom wall by appropriate choice of power to the respective heating elements. This may allow for a more even and uniform layer of precursor to be provided in the vessel, which may provide a more consistent and reliable flow of precursor out of the vessel.

The top wall may comprise an inlet port for supplying a precursor gas to the vessel. The top wall may comprise an outlet port for removing a precursor gas from the vessel. By providing the inlet and/or outlet port in the top wall, deposition of precursor on the inlet and/or outlet port can be substantially reduced or avoided, as the top wall may be maintained at a higher temperature than the side wall, as it is further removed from the bottom wall, which may in some embodiments need to be heated to a temperature suitable for deposition of precursor on the bottom wall.

By providing the vessel with inlet and outlet ports for gas input/output, precursor can be supplied to the vessel in gas form, which may have advantages over providing the precursor to the vessel in solvent form or in powder form. For example, use of a solvent to provide the precursor to the vessel followed by evaporation of the solvent in the vessel requires an additional drying step in the precursor refill process, may result in solvent contamination of the precursor to be extracted from the vessel, and is limited in capacity. Providing the precursor in powder form may causing clogging and a carried gas may be required in order to remove precursor from the vessel. By providing the gas supply inlet in the vessel, refill of precursor can be carried out without removing the vessel from its installation position.

The vessel may comprise a single gas port in the top wall and the single gas port may be configured to function as an inlet for supplying a precursor gas to the vessel and an outlet for removing precursor gas from the vessel. The vessel may comprise a switching valve for connecting the port to an inlet gas line when the port functions as an inlet, and for connecting the port to an outlet gas line when the port functions as an outlet, wherein the inlet gas line is separate to the outlet gas line.

The inlet and outlet ports may be separate ports which may be spaced apart along a dimension of the top wall. By providing separate inlet and outlet ports which are spaced apart, a purge gas flow may be provided from the inlet port, into the vessel and out of the outlet port.

The top wall, the bottom wall, and the side walls may form a container. The container may have a rectangular cross-section in a plane parallel to the bottom wall. This may allow for more efficient use of space in a gas cabinet in which multiple vessels are required to be accommodated.

The vessel may comprise a housing surrounding the container and the heaters, wherein the housing has a higher thermal conductivity than the walls of the container. This may allow for more even heating of the walls by redistribution of heat by the housing.

The housing may be arranged to provide an air gap between the housing and the bottom wall. This may allow for a larger temperature gradient between the bottom wall and the housing, which can be advantageous in applications wherein the bottom wall temperature needs to be rapidly changed.

The housing may comprise a set of spacers for spacing the housing apart from the bottom wall so as to provide the air gap.

The housing may have a bottom wall which is water-cooled. The vessel may comprise a water cooling conduit in or on the bottom wall of the housing, through which water can be flowed to cool the bottom wall of the housing. By providing water cooling to the bottom wall of the housing, the time needed for temperature change of the bottom wall of the vessel may be decreased as active cooling can be provided.

Each wall may comprise a recessed channel, and the heaters may comprise wires fitted into a recessed channel in the respective wall which they are configured to heat. This may allow for more efficient heat transfer to the walls and reduces the footprint of the vessel.

The vessel may have an interior volume of at least 0.01m3. The bottom wall may have a width which is at least 5 times a height of the side wall. The container has inner volume with a cross-sectional area in a plane parallel to the bottom wall which is at least 0.2 m2. These dimensions may each allow for a large amount of precursor to be provided in the vessel, which may be an advantage especially in applications wherein large quantities are required to be supplied to a processing apparatus containing multiple semiconductor wafers for processing, especially if the wafers have a high degree of surface enhancement. **In** such applications direct supply of precursor from a sub-fab bulk supply to a process chamber of a semiconductor apparatus may not provide sufficient quantity or flow rate. The vessel according to embodiments of the present invention allows large precursor quantities to be stored and made available to the process chamber.

Each heater may be individually controllable so as to allow each heater to output a different power than that which is output by the other heaters. This may be advantageous in applications wherein the walls have differing thermal characteristics such that a certain power input to a first heater for a first wall resulting in that wall attaining a first temperature does not result in the same temperature being attained by a second wall with a second heater receiving the same power input.

The vessel may comprise a valve in fluid communication with the inlet port, for controlling a flow of precursor gas into the vessel. The vessel may comprise a valve in fluid communication with the outlet port for controlling a flow of precursor gas out of the vessel.

The top wall heater may comprise at least two individually controllable heating elements. The bottom wall heater may comprise at least two individually controllable heating elements. The side wall heater may comprise at least two individually controllable heating elements. By providing more than one individually controllable heating element per wall, the temperature of the respective wall may be more finely controlled, for example in embodiments wherein a wall can be divided into zones, each having a differing heat capacity and therefore not attaining the same temperature if heated by heaters with the same input power.

The vessel may comprise a controller configured to individually control the top wall heater, the side wall heater, and the bottom wall heater. The controller may be configured to, in a precursor vessel refill mode, cause the top wall and the side walls to be heated to a temperature greater than a deposition temperature of a precursor to be supplied to the vessel, and to cause the bottom wall to be heated to a temperature less than or equal to the deposition temperature. This can allow deposition of precursor on the top and side walls to be prevented, resulting in a more uniform single layer of precursor on the bottom wall.

The controller may be configured to, in a precursor vessel supply mode, cause the bottom wall, the side wall, and the top wall to be heated to a temperature greater than or equal to a sublimation temperature of a precursor to be supplied from the vessel.

The bottom wall may be heated to a temperature which is less than a temperature to which the top and side walls are heated.

The vessel may comprise a booster heater which is individually controllable and separate to the bottom, side, and top wall heaters.

According to a second aspect of the present invention there is provided a method of operating a precursor vessel according to the first embodiment, comprising performing a precursor filling step which comprises closing the outlet port and flowing a precursor gas through the inlet port while causing the bottom wall to be maintained at a temperature less than or equal to a deposition temperature of the precursor gas and causing the top wall and the side walls to be heated to a temperature greater than the deposition temperature of the precursor gas. This can allow deposition of precursor on the top and side walls to be prevented, resulting in a more uniform single layer of precursor on the bottom wall.

The method may comprise performing a precursor supplying step after the precursor filling step, the precursor supplying step comprising closing the inlet port and opening the outlet port while causing the bottom wall, the side wall, and the top wall to be heated to a temperature greater than or equal to a sublimation temperature of a precursor to be supplied from the vessel.

The method may comprise, after the precursor filling step and before the precursor supplying step, performing a reflow step comprising closing the inlet port and the outlet port while causing at least one wall to be heated to a temperature greater than the melting point of the precursor for a predetermined duration. This can cause precursor in the vessel to melt and reflow to form a more uniform layer on the bottom wall.

According to a third aspect of the present invention there is provided a semiconductor processing apparatus comprising a vessel according the first aspect in fluid communication with a process chamber.

The process chamber may be configured to receive and process a plurality of substrates simultaneously.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Certain embodiments of the present invention will now be described, by way of example, with reference to the accompanying drawings, in which:
Figure 1a is a schematic perspective view of a precursor supply vessel according to embodiments of the present invention, showing with dashed lines components which are on a non-visible side of the vessel;
Figure 1b is a schematic perspective view of a precursor supply vessel according to embodiments of the present invention, in which components on a non-visible side of the vessel are omitted for clarity but nonetheless remain part of the vessel;
Figure 2a is a schematic plan view of a wall comprised in a vessel according to embodiments of the present invention comprising a channel for receiving a heater wire;
Figure 2b is a schematic plan view of a wall comprised in a vessel according to embodiments of the present invention comprising an undulating channel and a heater wire received in the channel;
Figure 2c is a schematic plan view of a wall comprised in a vessel according to embodiments of the present invention comprising two L-shaped channels and heater wires received in the channels;
Figure 3a is a schematic plan view of a wall comprised in a vessel according to embodiments of the present invention and a plurality of heaters arranged to heat at least part of the wall;
Figure 3b is a schematic plan view of a top wall comprised in a vessel according to embodiments of the present invention, the top wall being divided into a plurality of zones and each zone having an associated heater configured to heat that zone;
Figure 4 is a schematic cross-sectional view of a vessel according to embodiments of the present invention, comprising a housing;
Figure 5 is a schematic plan view of a bottom wall of the housing, including a water cooling conduit;
Figure 6 is a schematic view of a vessel according to embodiments of the present invention, comprising a controller;
Figure 7 is a schematic view of a semiconductor processing apparatus comprising a vessel according to embodiments of the present invention;
Figure 8 is a flow chart of a method of using a vessel according to embodiments of the present invention;
Figures 9a-9d are schematic views of a vessel according to embodiments of the present invention, in precursor (re)fill mode;
Figure 10 is a flow chart of a method of using a vessel according to embodiments of the present invention;
Figures 11a and 11b are schematic views of a vessel according to embodiments of the present invention, in precursor supply mode;
Figure 12a is a schematic cross-sectional view of a vessel according to embodiments of the present invention wherein the bottom wall comprises ribs;
Figure 12b is a schematic cross-sectional view of a vessel according to embodiments of the present invention, comprising a precursor tray which comprises ribs;
Figure 13 is a schematic cross-sectional view of a vessel according to embodiments of the present invention comprising a booster heater.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride and silicon carbide.

A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents thereof.

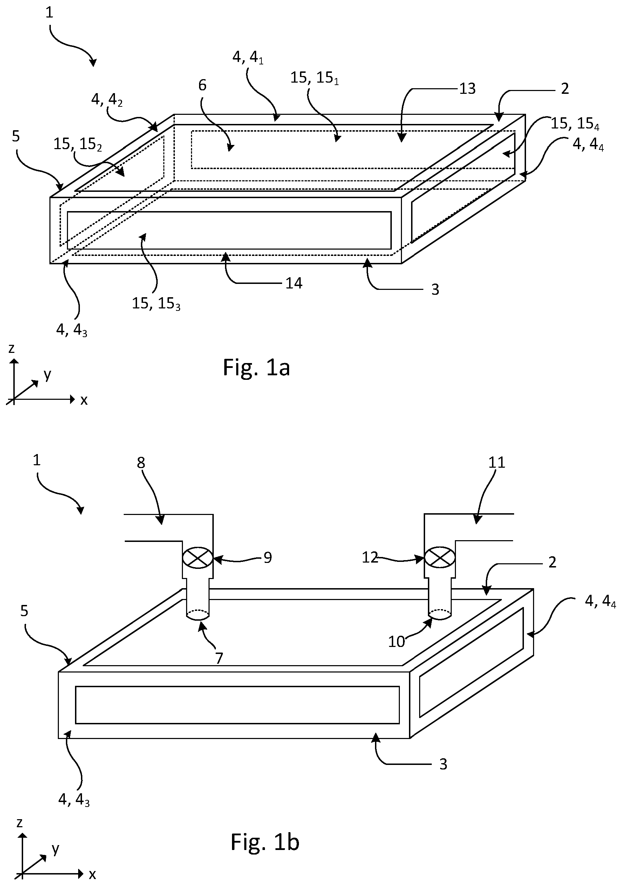

Referring to Figures 1a and 1b, a precursor supply vessel 1, also referred to herein as vessel 1, according to embodiments of the present invention comprises a top wall 2, a bottom wall 3, and a side wall 4 extending between the top wall 2 and the bottom wall 3, the walls 2, 3, 4 forming a container 5 enclosing an inner volume 6. The top wall 2, bottom wall 3, and side wall 4 may be substantially planar, i.e. having little to no curvature, thus providing a substantially cuboid shaped container 5 with an inner volume 6 having a rectangular cross-section in a plane parallel to the bottom wall 3. The side wall 4 may for example comprise four substantially planar parts 4₁, 4₂, 4₃, 4₄, each extending between the top wall 2 and the bottom wall 3 and disposed in opposing pairs.

The vessel 1 comprises an inlet port 7 for supplying a precursor gas to the vessel 1. The inlet port 7 may be disposed in the top wall 2. **In** some embodiments, the inlet port 7 may be disposed in (one of the parts of) the side wall 4. A supply gas line 8 for supplying a precursor gas to the vessel 1 may be connected in fluid communication with the inlet port 7. The supply gas line 8 may include a valve 9 upstream of the inlet port 7 and configured to control a flow rate and/or quantity of precursor gas to be supplied to the vessel 1 in gas form. The valve 9 may be, for example, a flow control valve or mass flow controller. The valve 9 may be a surface-mounted valve mounted on the top wall 2. The valve 9 may be a diaphragm valve.

The vessel 1 comprises an outlet port 10 for removing a precursor gas from the vessel 1. The outlet port 10 may be disposed in the top wall 2. In some embodiments, the outlet port 10 may be disposed in (one of the parts of) the side wall 4. An extraction gas line 11 providing a flow path for precursor gas removed from the vessel 1 may be connected in fluid communication with the outlet port 10. The extraction gas line 11 may include a valve 12 downstream of the outlet port 10 and configured to control a flow rate and/or quantity of precursor gas to be extracted from the vessel 1. The valve 12 may be, for example, a flow control valve or mass flow controller. The valve 12 may be a surface-mounted valve mounted on the top wall 2. The valve 12 may be a diaphragm valve.

The precursor supply vessel 1 comprises a top wall heater 13, a bottom wall heater 14, and a side wall heater 15. The top wall heater 13 is constructed and arranged to heat the top wall 2. The bottom wall heater 14 is constructed and arranged to heat the bottom wall 3. The side wall heater 15 is constructed and arranged to heat the side wall 4. The heaters 13, 14, 15 are individually controllable. That is, a first power may be supplied to the top wall heater 13, while a second power is supplied to the side wall heater 14 and a third power is supplied to the bottom wall heater 15. Since the heaters 13, 14, 15 are individually controllable, the three power values may be different or the same. One or more of the three power values may vary individually in time while the other power values are constant or vary in a different manner. The individual controllability may be achieved, for example, by having a separate power input for each heater 13, 14, 15. The side wall heater 15 may comprise a plurality of side wall heaters 15₁, 15₂, 15₃, 15₄, each disposed on a respective side wall part 4₁, 4₂, 4₃, 4₄. The plurality of side wall heaters 15₁, 15₂, 15₃, 15₄ may each be individually controllable, or may be controllable as a unit i.e. the same power input is provided to each of the plurality of side wall heaters.

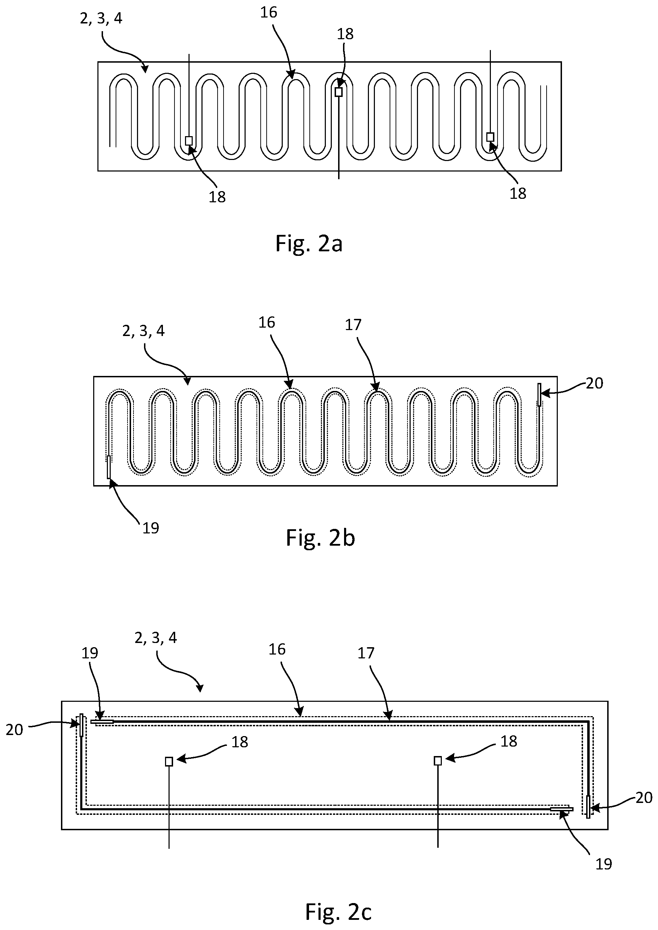

Referring to Figures 2a and 2b, a wall 2, 3, 4 of the vessel 1 may comprise a recessed channel 16 for receiving a heater wire 17. The recessed channel 16 may have an undulating shape. The heater wire 17 may be press-fitted into the channel 16. The heater wire 17, forming part of a heater 13, 14, 15, may comprise terminals 19, 20 at opposite ends for supplying current to the heater wire 17. Providing separate terminals 19, 20 for each heater 13, 14, 15 allows each heater to be individually controllable. The vessel 1 may comprise one or more temperature sensors, for example thermocouples, 18 disposed on each wall 2, 3, 4 for measuring a temperature of the respective wall.

The recessed channel 16 may have a shape other than an undulating shape. For example, referring to Figure 2c, the recessed channel 16 may have an L-shape. Two recessed channels 16₁, 16₂ may be provided in a wall 2, 3, 4, one being inverted with respect to the other, so as to receive heater wires 17. The heater wires 17 may then be disposed in a broken rectangle configuration. In some embodiments, the two L shaped channels 16₁, 16₂ may be provided in the side wall 4 and the undulating channels may be provided in the top and bottom walls 2, 3. In some embodiments, L-shaped channels and corresponding heater wires 17 may be provided in all walls 2, 3, 4. The L shaped channels may still allow a large area of a wall 2, 3, 4 to be heated in cases wherein the size of the wall 2, 3, 4 is insufficient to allow placement of an undulating channel.

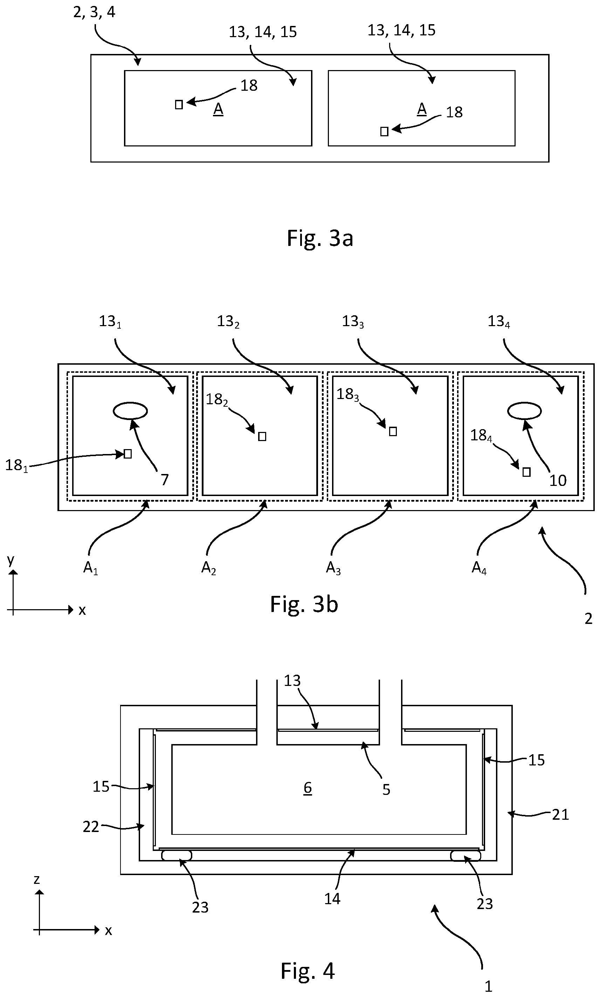

Referring to Figures 3a and 3b, each heater 13, 14, 15 on a respective wall 2, 3, 4 may comprise a plurality of heating elements 13, each of which is individually controllable. The plurality of heating elements 13 may each be arranged to heat a different zone A of the respective wall. This may be advantageous in a case where different zones have different heater power requirements in order to maintain all zones of a wall at the same temperature. The plurality of heating elements 13 may each be formed of a channel 16 and wire 17 press-fitted into the channel 16. Each channel 16 may be separate to or contiguous with a channel 16 of an adjacent heating element 13. Each zone A may comprise one or more temperature sensors 18, for example thermocouples, for measuring a temperature of a part of the wall in that zone.

For example, referring in particular to Figure 3b, the heater 13 for the top wall 2 may comprise a first top wall heating element 13₁ arranged to heat a first top wall zone A₁, a second top wall heating element 13₂ arranged to heat a second top wall zone A₂, a third top wall heating element 13₃ arranged to heat a third top wall zone A₃, and a fourth top wall heating element 13₄ arranged to heat a fourth top wall zone A₄. The vessel 1 may comprise a first thermocouple 18₁ for measuring a temperature of the first top wall zone A₁, a second thermocouple 18₂ for measuring a temperature of the second top wall zone A₂, a third thermocouple 18₃ for measuring a temperature of the third top wall zone A₃, and a fourth thermocouple 18₄ for measuring a temperature of the fourth top wall zone A₄.

The different zones may be adjacent to each other. The different zones may be chosen so as to target particular areas of the respective wall. For example, the first zone A₁ may include the inlet port 7. The fourth zone A₄ may include the outlet port 10. The second and third zones A₂, A₃ may be disposed between the first and fourth zones A₁, A₄. Each heating element 13₁, 13₂, 13₃, 13₄ may have separate input/output terminals 19, 20 so as to allow each heating element to receive an individually controllable input power. The first top wall heating element 13₁ may require a higher input power than the second top wall heating element 13₂ in order to maintain the first zone A₁ and the second zone A₂ at the same temperature, due to the presence of the inlet port 7 in the first zone A₁ which may increase the heat capacity of the first zone A₁. A similar requirement may apply to the fourth top wall heating element 13₄ due to the presence of the outlet port 10 in the fourth zone A₄. It will be understood that the bottom wall 3 and the side wall 4 may comprise zones and associated individually controllable heating elements in a similar manner.

In some embodiments, the side wall heater comprises separate heaters 15₁, 15₂, 15₃, 15₄. In such embodiments, each of the separate heaters 15₁, 15₂, 15₃, 15₄ may comprise a plurality of individually controllable heating elements, each arranged to heat a separate zone of the respective wall 4₁, 4₂, 4₃, 4₄.

Referring to Figure 4, in some embodiments the vessel 1 comprises a housing 21 arranged to surround the container 5 and the heaters 13, 14, 15. The housing 21 may have a higher thermal conductivity than the walls 2, 3, 4 of the container 5. For example, the walls 2, 3, 4 of the container 5 may be made of stainless steel and the housing 21 may be made of aluminum. The housing 21 may help to improve temperature uniformity of the walls 2, 3, 4 of the container 5. The housing 21 may be spaced apart from the bottom wall 3 of the container 5, and optionally also spaced apart from the side wall 4 of the container 5, by an air gap 22. By providing an air gap 22 between the housing 21 and the bottom wall 3 of the container 5, a greater temperature gradient can be provided between the housing 21 and the bottom wall 3. This may be advantageous in applications wherein a rapid change in temperature of the bottom wall 3, optionally also the side wall 4, is required, for example for efficiently cycling from a deposition temperature in a precursor refill mode to a sublimation temperature in a precursor supply mode. Preferably, there is no air gap between the top wall 2 and the housing 21. This may help to enable the top wall to quickly and uniformly attain and maintain a required temperature. The housing 21 may comprise spacers 23 for spacing apart the housing 21 and the bottom wall 3 so as to provide the air gap 22.

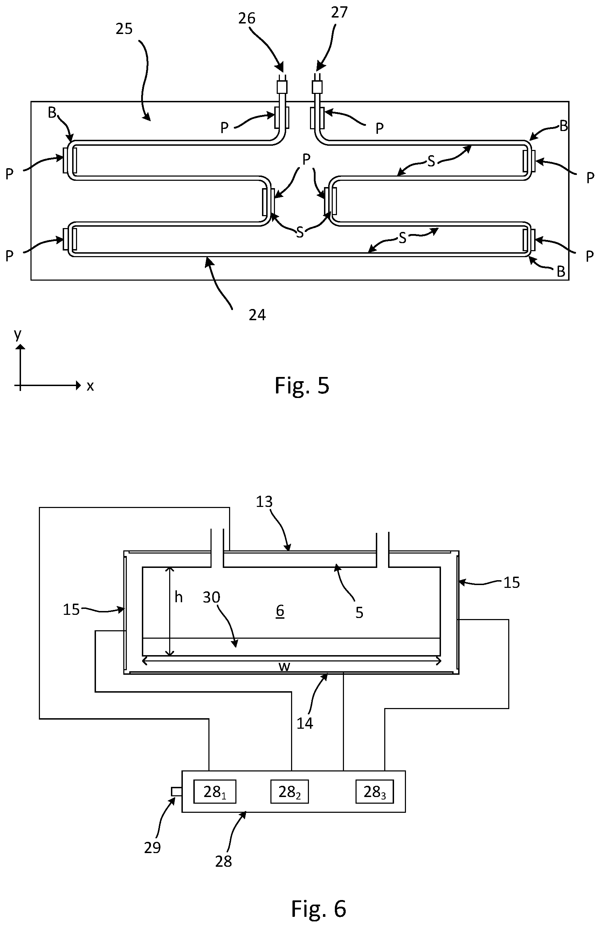

Referring to Figure 5, in some embodiments the vessel 1 comprises a water cooling conduit 24 arranged for cooling a bottom wall 25 of the housing 21. The water cooling conduit 24 may have an undulating form so as to distribute the water cooling effect over the bottom wall 25. For example, the water cooling conduit 24 may comprise a set of straight sections S connected by bowed sections B. The water cooling conduit 24 comprises an inlet 26 for supplying cooled water to the conduit 24 and an outlet 27 for removing water from the conduit 24. The bottom wall 25 of the housing 21 may comprise a recessed channel (not shown) for receiving the conduit 24. By receiving the conduit 24 in the recessed channel rather than providing the conduit 24 on a planar surface of the bottom wall 25, the water cooling effect may be increased. By cooling the bottom wall 25 of the housing 21, the bottom wall 3 of the container 5 may also be cooled, which can allow for a more rapid temperature change between a deposition temperature and a sublimation temperature. The housing 21 may comprise one or more thermal pads P comprising a material of relatively high thermal conductivity, such as silicone or thermal paste/cement, and disposed between the conduit 24 and the bottom wall 25 of the housing 21, which may help to improve thermal contact between the conduit 24 and the housing 21. In embodiments wherein the thermal conduit 24 has an undulating form, the thermal pads P may be disposed under the straight sections S, under the bowed sections B, or both.

Referring to Figure 6, the vessel 1 may comprise a controller 28 connected to the top wall heater 13, bottom wall heater 14, and side wall heater 15 so as to be capable of individually controlling a power supplied to each of the heaters 13, 14, 15. The controller 28 may comprise one or more inputs 29 for receiving data, for example from a central control module as will be described in more detail hereinafter, and/or from thermocouples 18. The controller 28 may comprise three controllers 28₁, 28₂, 28₃, configured to control, respectively, the top wall heater 13, bottom wall heater 14, and side wall heater 15. In some embodiments, one or more of the top wall heater 13, bottom wall heater 14, and side wall heater 15 may comprise two or more individually controllable heaters, for example as described hereinbefore in relation to the top wall heater 13 (although equally applicable to the bottom wall and side wall heaters 14, 15). In such embodiments, the controller 28 may be configured to individually control each heater within a set of heaters for a particular wall of the vessel 1. In some embodiments, the controller 28 may be configured to control flow of water into/out of the water cooling conduit 24, for example by controlling a valve for opening/closing a flow line connected to the inlet 26. The controller 28 may be configured to receive temperature data (e.g., a temperature value or a voltage or current or other data value representative of a temperature value) from the one or more thermocouples 18, optionally to convert the received data to a temperature value, for example in a processor (not shown) comprised in the controller 28, and to use the received data or temperature value to control one or more heaters or heating elements 13, 14, 15, for example to control a heater which is the closest heater and/or an adjacent heater to the thermocouple 18. The controller 28 may be configured to implement, for example, a control loop such as a proportional-integral-differential control loop to maintain the temperature of a wall at a particular setpoint, using the received data or converted data as input to the control loop.

The vessel 1 is configured to contain a precursor 30. The precursor 30 may be in solid, liquid, and/or gaseous form, depending on the particular mode of operation of the vessel 1, which operation will be described in more detail hereinafter. For illustration purposes, in Figure 6 the precursor 30 is shown in solid form in a layer at the bottom of the container 5. The precursor 30 may be a solid source precursor, i.e. a source chemical that is solid under standard conditions (room temperature and atmospheric pressure). Non-limiting examples of solid source precursors include molybdenum oxychloride, hafnium chloride, molybdenum chloride. The precursor 30 may be a liquid source precursor, i.e. a source chemical that is liquid under standard conditions. The vessel 1 is particularly suited for delivering vapor phase reactants to be used in a vapor phase reaction chamber. The vapor phase reactants can be used for deposition, e.g. Chemical Vapor Deposition or Atomic Layer Deposition (ALD).

Referring still to Figure 6, the inner volume 6 may have a volume of at least 0.005m³, preferably at least 0.01m³ or at least 0.015m³ or at least 0.02m³. By providing a large interior volume 6, a large quantity of precursor may be stored in the vessel 1, which may be particularly advantageous in applications wherein large quantities of gas phase precursor are required to be provided to a process chamber of a semiconductor processing apparatus, for example if the process chamber contains many substrates with high surface enhancement. The vessel 1 having such dimensions may be capable of providing a flow rate of at least 1 standard litre per minute of precursor gas through the outlet port 10. The bottom wall 3 may have a width w which is at least 5 times a height h of the side wall 4, preferably at least 10 times the height h of the side wall 4. The width w may be the smaller or the larger of the two dimensions of the bottom wall 3 in the x-y plane. By providing a vessel 1 with such a width to height ratio, a large inner volume 6 may be provided while the vertical profile of the vessel 1 is kept low. This can allow for vertical space to be saved when fitting the vessel 1 into, for example, a gas cabinet of a semiconductor processing apparatus, especially where more than one vessel 1 may be provided in the semiconductor processing apparatus. The inner volume 6 may have a cross-sectional area in a plane parallel to the bottom wall 3, the cross-sectional area being at least 0.1m², preferably at least 0.15m² or at least 0.2m² or at least 0.3m².

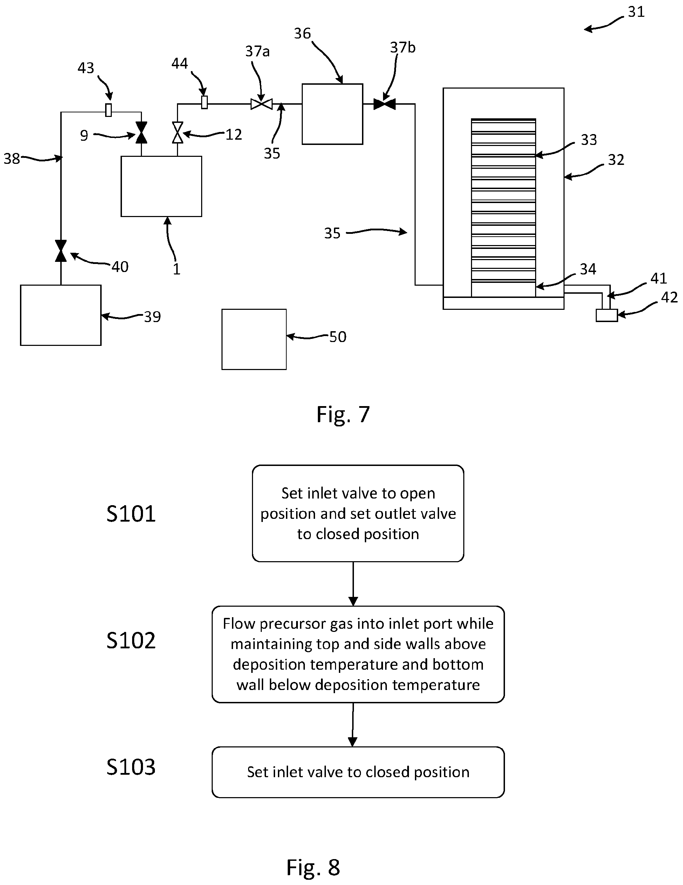

Referring to Figure 7, the vessel 1 may be comprised in a semiconductor processing apparatus 31 for processing semiconductor wafers. The semiconductor processing apparatus 31 may be a single wafer processing tool, or a batch processing tool such as a vertical furnace as illustrated in Figure 7. The semiconductor processing apparatus 31 is shown in Figure 7 in an accumulator supplying mode, as will be described in more detail hereinafter. The semiconductor processing apparatus comprises a process chamber 32 for receiving one or more wafers 33 on a wafer support 34. The process chamber 32 and the vessel 1 are adapted to be in selective fluid communication with each other through a first conduit 35 so as to feed the gas phase precursor from the vessel 1 to the process chamber 32. An accumulator 36 may be provided between and in fluid communication with the vessel 1 and the process chamber 32. The first conduit 35 includes one or more isolation valves 37a, 37b, which may be used for separating gas spaces of the vessel 1, the accumulator 36 (if present) and the process chamber 32. The accumulator 36 is configured to receive gas phase precursor from the vessel 1 and store the precursor in the gaseous state until a sufficient quantity has been collected in the accumulator 36. The gas phase precursor may then be released at a high flow rate into the process chamber 32. The accumulator 36 may advantageously allow for higher precursor flow rates into the process chamber 32 as compared with direct provision of precursor gas from the vessel 1 to the process chamber 32, which may help to improve throughput and deposited film quality.

The semiconductor processing apparatus 31 comprises a second conduit 38 for providing a gas flow path between the vessel 1 and a bulk precursor supply vessel 39. The bulk precursor supply vessel 39 is configured to contain the precursor in solid (or liquid) form and to provide gas phase precursor to the vessel 1 via the second conduit 38. The second conduit 38 includes one or more isolation valves 40 for separating gas spaces of the vessel 1 and the bulk precursor supply vessel 39. The bulk precursor supply vessel 39 has an internal volume for storing precursor which is greater than that of the vessel 1 and allows for large quantities of precursor to be stored for refilling the vessel 1.

The semiconductor processing apparatus 31 comprises a gas exhaust line 41 in fluid connection with the process chamber 32 and an exhaust pump 42, for evacuating gases from the process chamber 32. The exhaust pump 42 may be configured to provide a low pressure or vacuum state in the process chamber 32, which may cause a pressure differential between the process chamber 32 and the vessel 1 when the isolation valves 37a, 37b are not in a closed state, thereby causing precursor gas to be drawn from the vessel 1 into the process chamber 32.

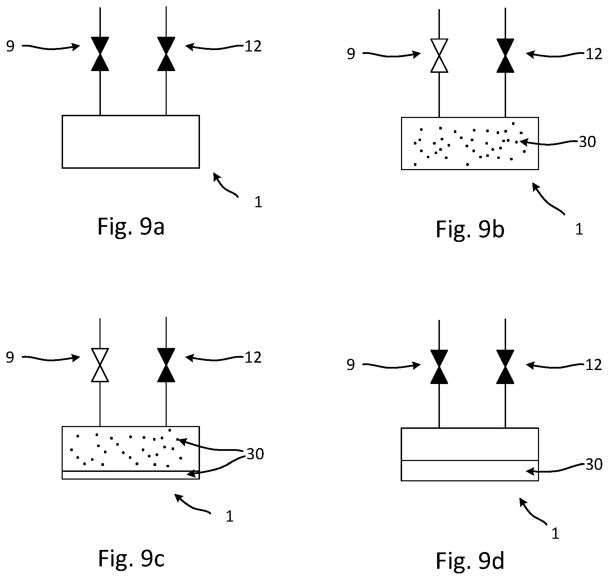

Referring to Figure 8, a method according to embodiments of the present invention of supplying precursor to the vessel 1 may proceed as follows. Supply may be re-supply, i.e. the vessel 1 may have previously contained precursor and may now be empty, or may contain a residual amount of precursor. Supply may be initial supply, i.e. the vessel 1 may have not previously contained precursor. For illustration purposes, in Figure 9a the vessel 1 is shown empty of precursor, before precursor supply begins. Referring also to Figure 9b, in step S101, the inlet valve 9 and optionally the isolation valve 40 (which may in some embodiments be the same valve) are set to an open position. In some embodiments, the inlet valve 9 and/or the isolation valve 40 may be set to a position which is not 100% open, for example in order to control a flow rate of the precursor. The outlet valve 12 is set to a closed position. In step S102, the bulk precursor supply vessel 39 is controlled to provide precursor gas 30 to the second conduit 38, for example by causing the bulk precursor supply vessel 39 to be heated above a sublimation temperature of the precursor such that part of the precursor contained in the bulk precursor supply vessel 39 transitions from solid to gas phase and flows through the second conduit 38. The top wall heater 13 and the side wall heater 15 are controlled to maintain the temperature of the top wall 2 and the side wall 4 above a deposition temperature of the precursor. The deposition temperature, or desublimation temperature, is the temperature of a wall at which the gas phase precursor transitions to solid phase and is deposited on the wall. The top wall and side wall heaters 13, 15 are controlled to maintain the respective wall temperature above this temperature so as to avoid deposition of the precursor on the top and side walls 2, 4. The bottom wall heater 14, and optionally the water cooling conduit, are controlled so as to maintain the temperature of the bottom wall below the deposition temperature. By controlling the heaters individually in this manner, the precursor can be induced to deposit on the bottom wall 3 of the vessel 1 and not on the top or side walls 2, 4 (Figure 9c). This can provide a more uniform layer of precursor in the container 5 which helps to provide a more consistent and uniform supply of precursor to the process chamber 32. By heating the top wall 2 during (re)supply, deposition of precursor on or in the inlet and outlet ports 7, 10 can be avoided, which can help to prevent clogging of the ports with solidified precursor.

In step S103, referring also to Figure 9d, once a required quantity of precursor has been provided to the vessel 1, which may be measured by time of supply of precursor gas to the vessel 1, flow rate of precursor into the vessel 1, pressure inside the vessel 1, pressure in the second conduit 38, or other parameters, the isolation valve 40 and the inlet valve 9 are set to a closed position. The vessel 1 may be maintained in this closed state until precursor gas is required to be supplied to the process chamber 32.

Optionally, after step S103, the top wall heater 13 and side wall heater 15 may be controlled to heat the top wall 2 and the side wall 4 to a temperature which is greater than a melting point of the precursor. This can allow any precursor which was nevertheless deposited on the top wall 2 or the side wall 4 to melt and flow to the bottom of the vessel 1, resulting in a more uniform layer of precursor at the bottom of the vessel 1. Optionally, after step S103, the bottom wall heater 14 may be controlled to heat the bottom wall 3 to a temperature which is greater than a melting point of the precursor. In some embodiments, the top wall 2 and/or the side wall 4 may be heated in this step by their respective heaters to a temperature above the precursor melting point. This can allow the precursor at the bottom of the vessel 1 to melt and re-flow to a more uniform layer, reducing nonuniformities on the surface of the precursor layer at the bottom of the vessel 1. Providing a more uniform layer of precursor at the bottom of the vessel 1 may allow for better repeatability in supply of precursor from the vessel 1.

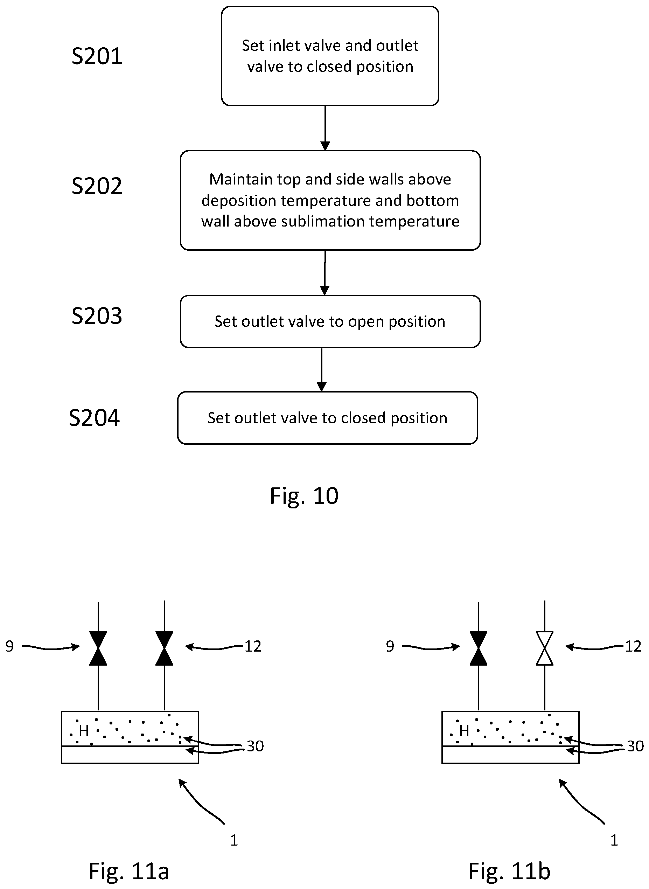

Referring to Figure 10, supply of precursor from the vessel 1 to the process chamber 32 may proceed according to a precursor supply method according to embodiments of the present invention. Referring also to Figure 11a, in step S201 the inlet valve 9 and optionally the isolation valve 40 are set to a closed position, if not already in such a state. The outlet valve 12 is set to a closed position. The isolation valve 37a may be set to a closed position or an open position. In step S202, the top wall heater 13 and the side wall heater 15 are controlled to maintain the temperature of the top wall 2 and the side wall 4 above the deposition temperature of the precursor. In some embodiments, the top wall heater 13 and the side wall heater 15 may be controlled to maintain the temperature of the top wall 2 and the side wall 4 above the sublimation temperature of the precursor, so as to sublimate any precursor which may nevertheless have been deposited on the top wall 2 or the side wall 4. The bottom wall heater 14 is controlled to maintain the temperature of the bottom wall 3 above the sublimation temperature of the precursor. In step S203, after a predetermined time period, during which the vapor pressure of the precursor in the headspace H of the vessel 1 is increased by sublimation of the solid state precursor, see Figure 11b, the outlet valve 12 is opened and precursor gas is allowed to flow out of the vessel 1 through the outlet 10. The headspace H is the volume within the vessel 1 above the surface of the solid state precursor and which can be occupied by gas phase precursor. The side wall heaters 13, 14, 15 are controlled to maintain the respective side walls 2, 3, 4 above the deposition or sublimation temperature (side and top walls) or above the sublimation temperature (bottom wall) as the solid state precursor continues to be sublimated and the resulting gas phase precursor is extracted via the outlet 10.

In some embodiments, the outlet valve 12 and the isolation valve 37a (if previously closed) are opened simultaneously with the initial temperature change of the walls 2, 3, 4 of the vessel 1 caused by controlling the heaters 13, 14, 15, i.e. there is no waiting time between causing the temperature of the bottom wall 3 to be above the sublimation temperature of the precursor and opening the outlet valve 10.

The gas phase precursor then flows through the first conduit 35 towards the accumulator 36 (if present) or the process chamber 32 (if no accumulator is present). **In** some embodiments, when the accumulator 36 is present, isolation valve 37b is maintained in a closed state and isolation valve 37a is maintained in an open state while precursor gas is supplied from the vessel 1 to the accumulator 36, until the accumulator stores a predetermined amount of precursor gas, which may be determined for example by measuring a flow rate of gas through the first conduit 35, and then the isolation valve 37a may be closed. When precursor gas is required to be supplied to the process chamber 32, isolation valve 37b may be opened to allow precursor gas to flow from the accumulator 36 into the process chamber 32.

The vessel 1 may be maintained in the supply mode until substantially all of the solid state precursor has been sublimated and extracted in gas form. The vessel 1 may be maintained in the supply mode until a predetermined amount of the solid state precursor remains in the vessel. This may be determined, for example, by providing a sensor 44, which may be for example a pressure sensor, flow rate sensor, or other type of sensor capable of measuring gas properties, downstream of the outlet port 10 for measuring an amount of precursor gas extracted from the vessel 1. A sensor 43, which may be for example a pressure sensor, flow rate sensor, or other type of sensor capable of measuring gas properties, may be provided upstream of the inlet port 7 for measuring an amount of precursor gas provided to the vessel 1. Once precursor gas is no longer required to be supplied from the vessel 1, the outlet valve 12 is set to a closed position (step S204). In some embodiments, the vessel 1 may be supported by load scales (not shown) which may measure a weight of the vessel 1 and thereby determine an amount of precursor remaining in the vessel. The load scales may be provided in addition to or instead of the sensors 43, 44.

In some embodiments, a bypass valve may be provided between the supply gas line 8 and the extraction gas line 11. The bypass valve may be connected between a point on the supply gas line 8 which is between the valve 9 and the input port 7, and a point on the extraction gas line which is between the valve 12 and the output port 10. When in an open position, the bypass valve allows direct gas flow between the supply gas line 8 and the extraction gas line 11. The bypass valve may be set to an open position during precursor supply to the vessel 1. This can allow for both the input port 7 and the output port 10 to be used as conduits for precursor gas flowing into the vessel 1. The bypass valve may be set to an open position during precursor extraction from the vessel 1. This can allow for both the input port 7 and the output port 10 to be used as conduits from precursor gas flowing out of the vessel 1.

The substrate processing apparatus 31 may comprise a central control unit 50 configured to control various functions of the apparatus 31, for example valve status, temperature of the process chamber 32, gas flow rate, pressure in the process chamber 32, opening/closing of the process chamber 32, operation of the exhaust pump 42, etc. The central control unit 50 may be configured to receive data from various components of the apparatus 31, for example pressure and/or flow rate data from valves 9, 12, 37a, 37b, 40, temperature data from one or more temperature sensors (not shown) in the process chamber 31, pressure data from one or more pressure sensors (not shown) in the process chamber 31. Electrical connections to the components of the substrate processing apparatus 31 are not shown. The central control unit 50 may comprise the controller 28 for the heaters 13, 14, 15. The central control unit 50 may be configured to send and receive data from the controller 28, for example in order to control functioning of the controller 28. For example, the central control unit 50 may store, in a memory, a series of instructions for carrying out a method according to embodiments of the present invention, and may load such instructions into a processor configured to execute the instructions so as to carry out the method. The method may be for example a precursor (re)fill method for example as described hereinbefore with reference to Figure 8, and/or a precursor supply method for example as described hereinbefore with reference to Figure 10.

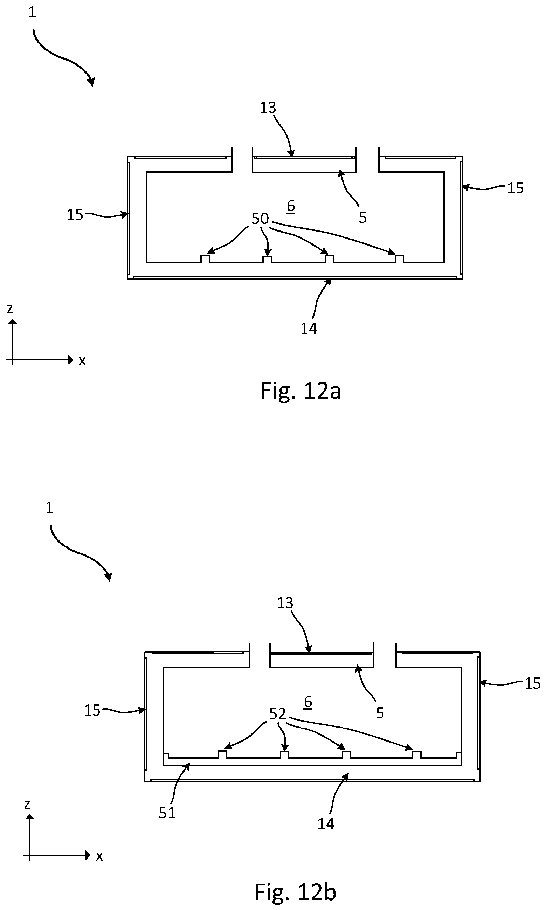

Referring to Figure 12a, in some embodiments, the bottom wall 3 comprises a set of ribs 50 which are spaced apart along a first dimension in the plane of the bottom wall 3 and extend along a second dimension in the plane of the bottom wall 3, the second dimension being perpendicular to the first dimension. The ribs 50 project upwards towards the top wall 2 and provide a means of strengthening the bottom wall 3 in embodiments wherein the vessel 1 is placed in a low pressure or vacuum environment. Referring to Figure 12b, in some embodiments, the vessel 1 comprises a tray 51 for receiving the solid or liquid state precursor. The tray 51 may be disposed at the bottom wall 3. In some embodiments, the tray 51 comprises a set of ribs 52 which are spaced apart along a first dimension in the plane of the tray 51 and extend along a second dimension in the plane of the tray 51, the second dimension being perpendicular to the first dimension. The ribs 52 project upwards towards the top wall 2 and provide a means of strengthening the tray 51 in embodiments wherein the vessel 1 is placed in a low pressure or vacuum environment.

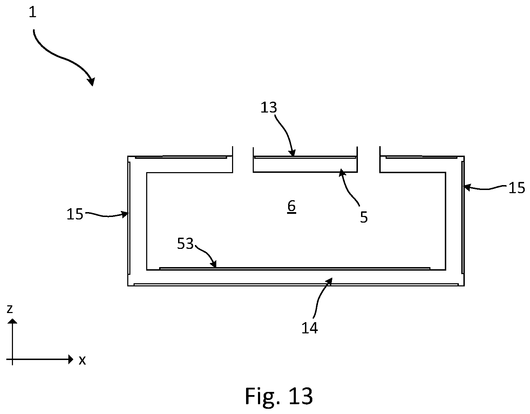

Referring to Figure 13, in some embodiments, the vessel may comprise an individually controllable booster heater 53, controllable by the controller 28. The booster heater 53 may be disposed in the interior volume 6, for example on the bottom wall 3, or on a side wall 4. The booster heater 53 may be disposed on the exterior of the bottom wall 3 or side wall 4. The solid state precursor may undergo a decrease in temperature when sublimation takes place. This can result in an increased temperature stabilization time, impacting throughput. The booster heater 53 functions to compensate for this temperature drop and decrease temperature stabilization time. The controller 28 may be configured to cause the booster heater to heat the solid state precursor in a predictive manner, for example to ramp up the power to the booster heater when a precursor supply process is initiated, so as to already be providing additional heat to the solid state precursor at the moment when sublimation begins and the temperature of the precursor drops.

Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments. The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. A precursor supply vessel comprising
a top wall, a bottom wall, and a side wall;
a top wall heater configured and arranged to heat the top wall, a bottom wall heater configured and arranged to heat the bottom wall, and a side wall heater configured and arranged to heat the side wall;
wherein each of the heaters is independently controllable.

2. The precursor vessel according to claim 1, wherein the top wall comprises an inlet port for supplying a precursor gas to the vessel.

3. The precursor vessel according to claim 1 or 2, wherein the top wall comprises an outlet port for removing a precursor gas from the vessel.

4. The precursor vessel according to any one of claims 1-3, wherein the top wall, the bottom wall, and the side walls form a container having a rectangular cross-section in a plane parallel to the bottom wall.

5. The precursor vessel according to any one of claims 1-4, further comprising a housing surrounding the container and the heaters, wherein the housing has a higher thermal conductivity than the walls of the container.

6. The precursor vessel according to claim 5, wherein the housing is arranged to provide an air gap between the housing and the bottom wall.

7. The precursor vessel according to claim 5 or 6, comprising a conduit disposed in or on the bottom wall of the housing, through which water can be flowed to cool the bottom wall of the housing.

8. The precursor vessel according to any one of claims 1-7, having an interior volume of at least 0.01m³.

9. The precursor vessel according to any one of claims 1-8, wherein each wall comprises a recessed channel, and wherein the heaters comprise wires fitted into a recessed channel in the respective wall which they are configured to heat.

10. The precursor vessel according to any one of claims 1-9, wherein the bottom wall has a width which is at least 5 times a height of the side wall.

11. The precursor vessel according to any one of claims 1-10, wherein the container has inner volume with a cross-sectional area in a plane parallel to the bottom wall which is at least 0.2 m².

12. The precursor vessel according to any one of claims 1-11, wherein each heater is individually controllable so as to allow each heater to output a different power than that which is output by the other heaters.

13. The precursor vessel according to any one claims 1-12, wherein the top wall heater, the bottom wall heater, and the side wall heater each comprise at least two individually controllable heating elements.

14. The precursor vessel according to any one of claims 1-13, comprising a controller configured to individually control the top wall heater, the side wall heater, and the bottom wall heater.

15. The precursor vessel according to claim 14, wherein the controller is configured to, in a precursor vessel refill mode, cause the top wall and the side walls to be heated to a temperature greater than a deposition temperature of a precursor to be supplied to the vessel, and to cause the bottom wall to be heated to a temperature less than or equal to the deposition temperature.

16. The precursor vessel according to claim 14, wherein the controller is configured to, in a precursor vessel supply mode, cause the bottom wall, the side wall, and the top wall to be heated to a temperature greater than or equal to a sublimation temperature of a precursor to be supplied from the vessel.

17. A method of operating a precursor vessel according to any one of claim 1-16, comprising performing a precursor filling step which comprises closing the outlet port and flowing a precursor gas through the inlet port while causing the bottom wall to be maintained at a temperature less than or equal to a deposition temperature of the precursor gas and causing the top wall and the side walls to be heated to a temperature greater than the deposition temperature of the precursor gas.

18. A method according to claim 17, comprising performing a precursor supplying step after the precursor filling step, the precursor supplying step comprising closing the inlet port and opening the outlet port while causing the bottom wall, the side wall, and the top wall to be heated to a temperature greater than or equal to a sublimation temperature of a precursor to be supplied from the vessel.

19. A method according to claim 18 comprising, after the precursor filling step and before the precursor supplying step, performing a reflow step comprising closing the inlet port and the outlet port while causing at least one wall to be heated to a temperature greater than the melting point of the precursor for a predetermined duration.

20. A semiconductor processing apparatus comprising a vessel according to any one of claims 1-16 in fluid communication with a process chamber, wherein the process chamber is configured to receive and process a plurality of substrates simultaneously.
